# EUROPEAN PATENT APPLICATION

(11) **EP 4 793 676 A1**
(43) Date of publication of application: **19.08.2026**
(21) Application number: 25158165.8
(22) Date of filing: 17.02.2025
(51) Int. Cl.: G02B 5/08, G02B 27/00, G03F 7/00, G02B 1/12

(54) **MAINTENANCE OF MULTILAYER OPTICAL COMPONENTS**

(71) Applicant: ASML Netherlands B.V., 5500 AH Veldhoven (NL); Carl Zeiss SMT GmbH, 73447 Oberkochen (DE)
(72) Inventor: BALTUSSEN, Sander, 5500 AH Veldhoven (NL); KOLESNYCHENKO, Aleksey, Yurievich, 5500 AH Veldhoven (NL)
(74) Representative: ASML Netherlands B.V.

(57) **Abstract**

A method of maintenance for a multilayer optical component. The multilayer optical component is configured for use with a lithographic process and comprises at least a first layer and a second layer adjacent to the first layer. The method comprises irradiating, with first ions, a region of the first layer such that particles are ejected from the first layer. The first ions have an energy at or above a sputter threshold of the first layer and the energy is below a sputter threshold of the second layer.

## Description

### FIELD

The present invention relates to multilayer optical components for use with a lithographic process and, in particular, maintenance of such components.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask or a reticle) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 2-20 nm, for example 6.7 nm or 13.5 nm, may be used to form smaller features on a substrate than a lithographic apparatus which uses, for example, radiation with a wavelength of 193 nm.

Optical components of a lithographic apparatus may comprise multiple layers. For example, optical components may be provided with multiple coatings. That is, the component may be a multilayer optical component. For example, the coating may be provided to ensure the optical component has a sufficient reflectivity for EUV radiation.

Through prolonged use, the performance of the component may be reduced from an initial, nominal performance. The reduction in performance may be due to an impaired layer of the component. For example, the impaired layer may have been contaminated by contaminants. As a further example, the impaired layer may have blistered. That is, gas bubbles may have formed in the layer. As a further example, the impaired layer may have blended with one or more other layers. In other words, the component may be impaired in some way.

Certain methods of cleaning are not appropriate for use with all components and / or all types of impairment. Thus, there is no method of maintaining certain components once the components have been impaired.

### SUMMARY

In a first example described herein, there is a method of maintenance for a multilayer optical component configured for use with a lithographic process and comprising at least a first layer and a second layer adjacent to the first layer the method comprises irradiating, with first ions, a region of the first layer such that particles are ejected from the first layer. The first ions have an energy at or above a sputter threshold of the first layer and the energy is below a sputter threshold of the second layer.

Performance of the multilayer optical component (i.e. the component) may have been previously reduced from a nominal performance to below an acceptable level. Beneficially, the method of maintenance may allow for removal of one or more (individual) layers of the multilayer optical component. That is, the impaired layer may be removed. It will be appreciated that, in examples where the impaired layer is not a surface layer, additionally layer may also be removed such that the impaired layer itself may be removed.

The one or more removed layers may be subsequently replaced. Thus, the component may provide the nominal performance after being maintained in this way. In other words, the component may be cleaned and / or repaired.

It will be appreciated that the region of the first layer may any appropriate region. For example, the region may correspond to an entire surface of the first layer. Alternatively, the region may correspond to a region that is less than the entire surface.

Within the region, the first layer may be removed in full. Alternatively, within the region, the first layer may be only partially removed.

The sputter threshold may be dependent on the species of the first ions and the material composition of the corresponding layers of the multilayer optical component. That is, the sputter threshold may be a threshold energy at which the first ions induce particles to sputter from the first layer. For example, the sputter threshold of the first layer may be different if helium ions are used to irradiate the first layer compared to if argon ions are used to irradiate the first layer. Similarly, the sputter threshold may be different if the first layer comprises ruthenium compared to if the first layer comprises silicon. The energy of the first ions may be the kinetic energy of the first ions.

The second layer may be the layer that is adjacent to the first layer. In other words, the second layer may be 'below' the first layer. Removing the first layer may expose the second layer. The first and second layer may each comprise different elements. Thus, the first and second layer may have different sputtering thresholds for the same ion species.

By irradiating the first layer with ions with an energy below the sputter threshold of the second layer, the ions may cause minimal particles to be ejected from the second layer. In particular, the ions may cause no particles to be ejected from the second layer. Beneficially, by irradiating the first layer in this way, particles may only be ejected from the first layer.

The lithographic process may be an EUV lithographic process. Alternatively, the process may be a DUV lithographic process.

The multilayer optical component may be a mirror or a patterning device. For example, the patterning device may be, or may be referred to, as a reticle. More generally, the component may be any appropriate component configured to use in a lithographic apparatus or lithographic tool. As an example, the mirror may be a collector mirror. That is, the mirror may be configured to be provided in a EUV source to direct EUV radiation immediately after the EUV radiation is generated.

Irradiating the first layer with first ions may comprise irradiating the first layer with noble gas ions. In particular, the first ions may be helium ions, argon ions, xenon ions; neon ions and / or krypton ions. Additionally or alternatively, the first ions may comprise hydrogen.

The first layer may be a surface layer of the multilayer optical component. That is, the first layer may be a 'top' layer of the component. For example, the first layer may be a cap layer. The first layer may comprise ruthenium. The first layer may comprise zirconium, for example, zirconium dioxide.

The first layer may comprise ruthenium, molybdenum, silicon, boron and / or carbon. It will be appreciated that when the first layer comprises a particular element, the particles ejected from the region of the first layer may also comprise the particular element. For example, if the first layer comprises ruthenium, the particles ejected from the first layer may also comprise ruthenium.

Irradiating the first layer with first ions may comprise irradiating the first layer with ions with an energy below the sputter threshold for the second layer by at least 5 eV.

The method may further comprise subsequent to irradiating the first layer, irradiating, with second ions, a second layer such that particles are ejected from the second layer. In this way, multiple layers may be removed from the component.

Similar considerations as discussed above in relation to the first layer and the first ions may apply to the second layer and the second ions. For example, the second ions may have an energy above a sputter threshold for the second layer. Additionally or alternatively, the second ions may have an energy below a sputter threshold for a third layer, below the second layer. The first and second ions may be different species of ions.

The method may further comprise removing the multilayer optical component from an EUV apparatus; and subsequent to removing the multilayer component from the EUV apparatus, irradiating the first layer with first ions. That is, the component may be removed from a position in which the component is typically used. For example, a mirror may be removed from a lithographic apparatus.

The method may further comprise reducing a pressure to below ambient pressure. In particular, the pressure may be reduced to a vacuum. In this way, contamination of the component may be reduced. Particles that have been ejected from the component may also be removed to prevent the particles accumulating on the component in any unintended manner.

The method may further comprise after irradiating a first region of the first layer with ions, moving the multilayer optical component; and irradiating, with first ions, a second region of the first layer such that particles are ejected from the second region. That is, the component may be moved such that different regions of the first layer are exposed to the first ions. Additionally or alternatively, the component may be moved such that different regions of other layers are exposed to ions. Additionally or alternatively, the first ions may be directed to the second region. For example, an electromagnetic field may be applied to direct the first ions to the second region.

The method may further comprise determining a property of the particles ejected from the region. For example, a mass spectrometer may be used to determine the property. The property may be a mass of the particles. The property may be a mass distribution. The property may be a number of particles.

The method may further comprise determining a property of the first ions. For example, based on determined property of the particles, an energy of the first ions may be determined.

In response to determining the property of the particles and / or the property of the first ions, a property of the first ions may be adjusted. For example, adjusting the property of the first ions may comprise increasing or decreasing an energy of the ions. The energy may be a nominal energy or an average energy. That is, the first ions may not all have the same energy and may form an energy distribution with an average or peak value. The property of the first ions may be adjusted such that the average or peak value is adjusted. The determined property of the first ions may be the same property as the adjusted property of the first ions. That is, the energy of the ions may be determined and then adjusted.

As a further example, adjusting the property of the first ions may comprise changing the species of ions. That is, the number of particles being ejected from the component may be determined and, in response to the number falling below a threshold, it may be inferred that a sufficient depth of the first layer has been removed in a first region. Thus, a second layer (previously obscured by the first layer) can now be exposed to ions. The species of ions may be changed to remove the second layer.

Additionally or alternatively, the component may be moved in response to determining the property. That is, the number of particles being ejected from the component may be determined and, in response to the number falling below a threshold, it may be inferred that a sufficient depth of the first layer has been removed in a first region. Thus, the component may be moved to expose the second region to the first ions.

The method may further comprise, for at least one layer of the component from which particles have been ejected, depositing atoms on the component to at least partially form a layer. In other words, a removed layer may be replaced. Each layer that has been removed may be replaced. The replacement of layers may be performed in reverse order compared to an order in which layers are removed.

In examples in which a layer has been partially removed, atoms may be deposited on the component such that the layer is partially reformed. The atoms may be deposited using any appropriate method, for example, any thin film deposition method. The atoms may be deposited on the component after being ejected from a particle source. The particle source may be a source of ruthenium, molybdenum, silicon, boron and / or carbon. As an example, the particle source may be irradiated, with ions, such that particles are ejected from the particle source and accumulate on the multilayer optical component. Thus by exposing the particle source to ions when the particle source is proximal to the component, particles ejected from the source may accumulate on the component to form a layer. As a further example, the particle source may be irradiated with electrons emitted by a filament by thermionic emission. As a further example, the particle source may be irradiated by an radio-frequency (RF) driven plasma.

The component may be re-coated in a same or similar way in which the original layers were formed. Even more generally, layer may be replaced using any other appropriate method known in the art. For example, the layer may be replaced using any thin film deposition method, including, for example, physical vapor deposition (PVD), atomic layer deposition (ALD) and / or chemical vapour deposit (CVD).

In a second example described herein, there is an apparatus configured to perform the method of the first example.

In a third example described herein, there is a non-transitory computer-readable memory storing instructions, which, when executed causes one or more computer systems to control an apparatus to perform the method of the first example.

In a fourth example described herein, there is a computer system, the computer system comprising: a plurality of processors: one or more non-transitory computer readable media storing computer readable instructions that when executed cause the plurality of processors to perform the method of the first example.

In a fifth example described herein, there is a multilayer optical component configured for use with a lithographic process that has been maintained according to the method of the first example.

A lithographic apparatus may comprise the multilayer optical component of the fifth example. A lithographic tool may comprise the multilayer optical component of the fifth example.

In a sixth example described herein, there is an apparatus for maintaining a multilayer optical component configured for use with a lithographic process and comprising at least a first layer and a second layer adjacent to the first layer. The apparatus may comprising: an ion source configured to, in use, irradiate a region of the first layer with first ions. The first ions may have an energy at or above a sputter threshold of the first layer such that particles are ejected from the first layer; and the first ions have an energy below a sputter threshold of the second layer.

As the first ions have an energy below a sputter threshold of the second layer, minimal particles may be ejected from the second layer. Minimal particles being ejected from the second layer may correspond to no particles being ejected from the second layer. The ion source may be, for example, a magnetron.

The ion source may be linear.

The ion source may be an inverted magnetron ion source.

The ion source may be a source of noble gas ions. For example, the ion source may provide helium ions, argon ions, xenon ions; neon ions and / or krypton ions. Additionally or alternatively, ion source may provide ions comprising hydrogen.

The ion source may be configured to provide ions at a selectable energy.

The apparatus may comprise a component configured to releasable secure the multilayer optical component.

The apparatus may comprise a component configured to move the multilayer optical component.

The apparatus may comprise a mass spectrometer.

The apparatus may comprise a vacuum source. The apparatus may further comprise an air lock. The apparatus may further comprise a load-lock.

The apparatus may comprise a second ion source configured to, in use, irradiate a layer of the multilayer optical component with second ions such that particles are ejected from the layer. For example, the second ion source may provide second ions that cause particles to be ejected from a second layer (i.e. a different layer to the first layer).

The apparatus may comprise a particle source configured to, in use and upon exposure to ions, eject particles such that the ejected particles accumulate on the multilayer optical component.

### BRIEF DESCRIPTION OF THE DRAWINGS

Embodiments of the invention will now be described, by way of example only, with reference to the accompanying schematic drawings, in which:
- Figure 1 depicts a lithographic system comprising a lithographic apparatus and a radiation source;
- Figure 2A depicts a first example multilayer optical component configured for use with a lithographic process;
- Figure 2B depicts a second example multilayer optical component configured for use with a lithographic process;
- Figure 3 is a flow diagram showing an example method of maintaining a multilayer optical component;
- Figure 4 depicts an example apparatus for maintaining a multilayer optical component; and
- Figure 5 is a flow diagram showing a second example method of maintaining a multilayer optical component.

### DETAILED DESCRIPTION

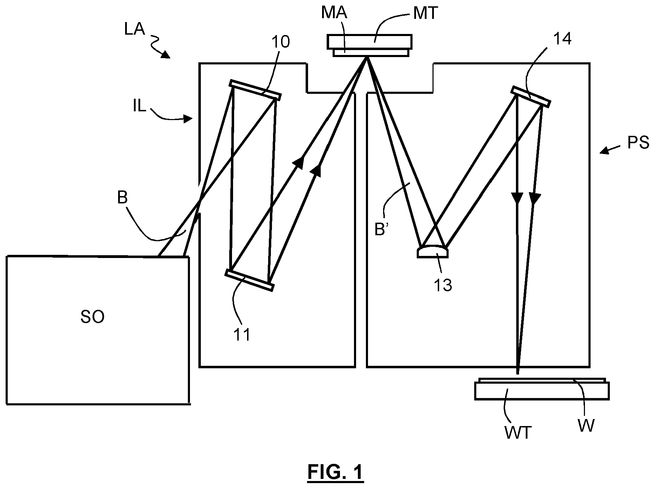

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask or a reticle), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13, 14 in Figure 1, the projection system PS may include a different number of mirrors (e.g. six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

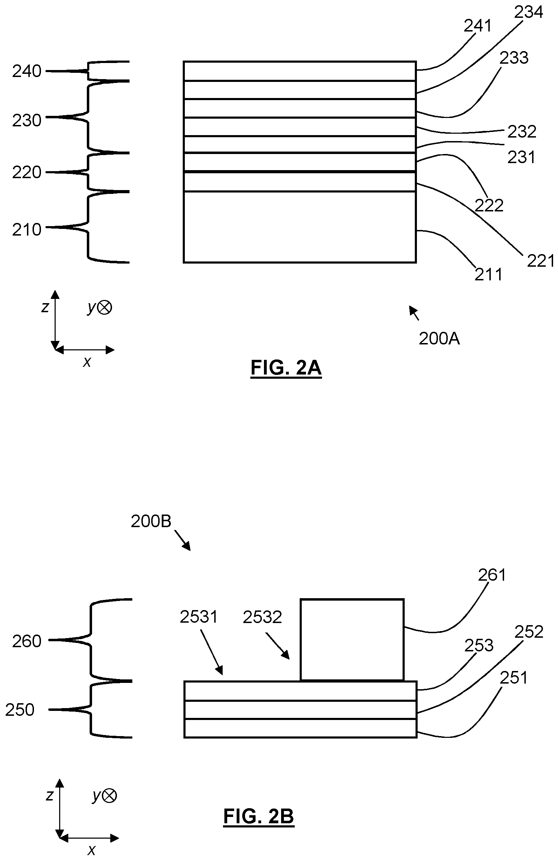

Figure 2A depicts a first example multilayer optical component 200A configured for use with a lithographic process. In particular, the component 200A is a mirror. The mirror 200A is configured to reflect lithographic radiation, such as the EUV radiation beam B, B'.

In some examples, the mirror 200A may be a collector mirror. That is, the mirror 200A may be configured to reflect lithographic radiation in the radiation source SO. In other examples, the mirror 200A may be one of the mirrors provided in the illumination system IL and / or the projection system PS. In particular, the mirror 200A may be, or may form part of, the facetted field mirror device 10, the facetted pupil mirror device 11 or any one of the plurality of mirrors 13, 14.

While the component 200A is described as a mirror in relation to Figure 2A, it will be appreciated that this is merely exemplary and the component may be any multilayer optical component.

To assist with describing the Figure, Figure 2A shows a Cartesian x-y-z coordinate system, with the y dimension extending into and out of the page (as indicated with the ⊗ symbol). Each layer of the mirror 200A may be considered to define a surface extending in a plane in the x-y dimension. Each layer of the mirror 200A may be considered to have a depth in the z dimension. Generally speaking, each layer of the mirror 200A may extend substantially further in the x and y dimensions compared to the z dimension. Each layer may be a different size. For example, layers may have different depths.

As shown in Figure 2A, the mirror 200A comprises multiple layers. For convenience, the multiple layers are depicted as being arranged into multiple sets of layers 210, 220, 230, 240. Each set of layers 210, 220, 230, 240 may comprise one or more layers. In some examples, adjacent layers (e.g. layers 233, 234) may be formed of the same material. As such, there may be no discernible difference between the adjacent layers. In other examples, adjacent layers may be formed of different materials. In some examples, one of more layers may be formed of the same material. For example, as discussed below in more detail, layers 232, 234 may be formed of the same material. Each set of layers 210, 220, 230, 240 may have layers arranged into a repeating pattern. That is, the layers may form a periodic structure. The pattern may repeat in the z direction. For simplicity, Figure 2A depicts a single period of each set of layers 210, 220, 230, 240. For example, the third set of layers 230 is depicted as comprising a single period of first, second, third and fourth layers 231, 232, 233, 234. However, the third set of layers 230 may comprise any number of periods of the first, second, third and fourth layers 231, 232, 233, 234. In each period, the first, second, third and fourth layers 231, 232, 233, 234 may be arranged in the same order such that a fourth layer 234 of a first period is adjacent to a first layer 231 of a second period. As an example, the third set of layers may comprise 50 periods.

As discussed below in more detail, one or more of the multiple layers of the mirror 200A may be a high refractive index layer i.e. formed of a material with a relatively high refractive index. As an example, the high refractive index layer may comprise molybdenum. One or more of the multiple layers may be a low refractive index layer i.e. formed of a material with a relatively low refractive index. As an example, the low refractive index layer may comprise silicon. When combined, the high refractive index layers and the low refractive index layers may provide sufficient reflectivity for use in the lithographic apparatus LA. That is, upon a EUV radiation beam B irradiating a first layer of the mirror 200A (i.e. at a first boundary), a portion of the EUV radiation beam B may be reflected and a portion may be refracted. Thus, the refracted portion may irradiate a second layer of the mirror and be at least partially reflected by the second layer (i.e. at a second boundary). By providing the mirror 200A with multiple high refractive index layers and multiple low refractive index layers, multiple portions of the EUV radiation beam B may be reflected. That is, each boundary may reflect a portion of the EUV radiation beam B. In particular, the layers of the mirror 200A may be arranged such that the multiple reflected portions constructively interfere.

To improve thermal stability of the mirror 200A, a barrier layer may be provided between a high refractive index layer and a low refractive index layer. As an example, the barrier layer may comprise carbon, boron carbide (B₄C), and / or silicon carbide (SiC).

In the example of Figure 2A, the mirror 200A comprises a substrate 211. As an example, the substrate 211 may be formed from glass. While the substrate 211 is depicted in Figure 2A as a single layer, it will be appreciated that the substrate 211 may be formed of multiple layers and thus may be referred to as the first set of layers 210.

The second set of layers 220 comprises a first layer 221 and a second layer 222. The second set of layer 220 may be configured to reduce an amount of radiation that the substrate 211 is exposed to. In other words, the second set of layers 220 may block the EUV radiation beam B from reaching the substrate 211.

The third set of layers 230 may be provided to reflect the EUV radiation beam B as discussed above. That is, the third set of layers 230 may cause constructive interference of the reflected portions of the EUV radiation beam B'. The third set of layers 230 comprises first, second, third and fourth layers 231, 232, 233, 234. The first layer 231 may be a low refractive index layer. The third layer may be a high refractive index layer. The second and fourth layers 232, 234 may a barrier layers.

The fourth set of layers 240 may be provide to prevent deterioration of the third set of layers 230. For example, the fourth set of layers 240 may reduce oxidation of the third set of layers 230. The fourth set of layers 240 may be referred to as a cap. In the example of Figure 2A, the fourth set of layers 240 comprises a first layer 241. As an example, the fourth layer may comprise ruthenium and / or zirconium. For example, the fourth layer may comprise RuB₄C, RuMo, and / or RuMoB₄C.

Figure 2B shows a second example 200B multilayer optical component. In particular, the component 200B is a patterning device, such as the patterning device MA. The patterning device 200B comprises a first and second set of layers 250, 260.

The first set of layers 250 may be similar to the layers of the mirror 200A. While the first set of layers 250 is depicted as comprising three layers 251, 252, 253, it will be appreciated that the first set of layers 250 may comprise additional layers. The layer 253 may be a cap and may comprise ruthenium. The layers 251, 252 may each be ones of a set of layers configured to reflect the EUV radiation beam B. For example, layer 251 may be a high refractive index material such as molybdenum. The layer 252 may be a lower refractive index material such a silicone.

The second set of layers 260 comprises one or more layers of an absorber 261. That is, the absorber 261 is configured to absorb the EUV radiation beam B such that there is minimal reflection of the EUV radiation beam B in a region obscured by the absorber 261. The absorber 261 may obscure a region of the surface of the layer 253. That is, the absorber 261 may not obscure the entire surface of the layer 253. As shown in Figure 2B, the absorber 261 obscures a region 2532 of the surface of the layer 253. There is a region 2531 that is exposed (i.e. not obscured). As such, the patterning device 200B may only reflect the EUV radiation beam B in the exposed region 2531. In this way, the patterning device 200B may pattern the reflected EUV radiation beam B' with a pattern formed by the absorber 261. As an example, the absorber 261 may comprise tantalum and / or boron. For example, the absorber 261 may comprise tantalum boride (TaB).

Through prolonged use, the performance of a multilayer optical component (e.g. the mirror 200A or the patterning device 200B) may be reduced. For example, the component may be impaired. In particular, a layer of the component may be impaired and thus the layer may not perform in a nominal manner.

As a first example, the impaired layer may have been contaminated by contaminants. That is, contaminant particles (e.g. tin) may have accumulated on a surfaced of the layer. For example, contaminant particles may have accumulated on the layer 241 of the mirror 200A. As an alternative example, contaminant particles may have accumulated on the layer 253 of the patterning device 200B. Once contaminated in this way, a reflectivity of the component may be reduced. That is, an intensity of a reflected EUV radiation beam B' may be reduced due to the contamination.

As a second example, the impaired layer may have blistered. That is, gas bubbles may have formed between the impaired layer and an adjacent layer. Prior to the blistering, there may have been a single boundary between the impaired layer and an adjacent layer. Subsequent to the blistering, there may be a first boundary between the impaired layer and the gas (in the gas bubble) and a second boundary between the gas and the adjacent layer. As such, the EUV radiation beam B may not be reflected by the component in an expected way. Accordingly, an optical performance of the component may be reduced.

As a third example, the impaired layer may have blended with an adjacent layer. That is, during use, the component may have been heated to a temperature. The temperature may have been sufficiently high to result in the impaired layer and / or the adjacent layer to at least partially diffuse. In other words, the layers may undergo solid state diffusion. As such, a boundary between the impaired layer and the adjacent layer may have blended reducing an optical performance of the component. It will be appreciated that such processes may occur at a temperature below a melting point of the layers.

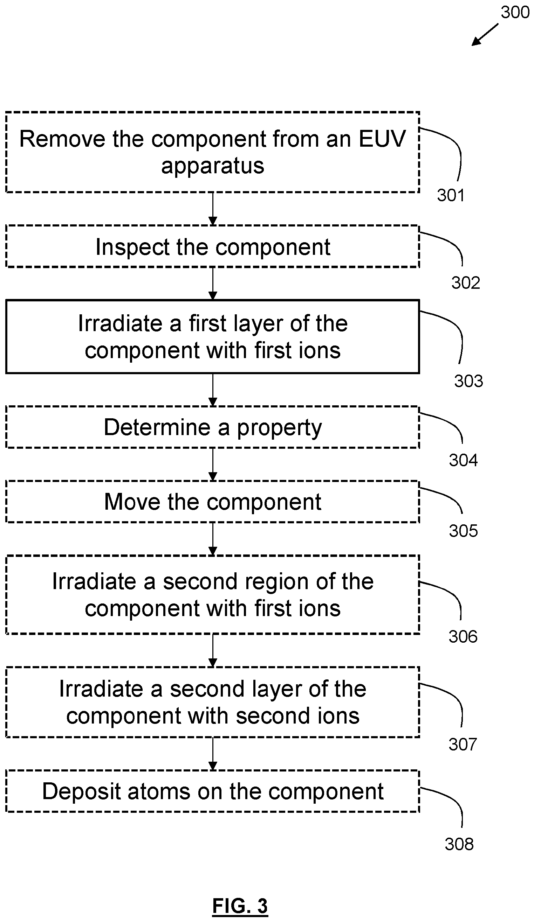

Figure 3 is a flow diagram showing a method 300 of maintenance for a multilayer optical component. In Figure 3, optional steps are indicated by dashed lines. At optional step 301, the component is removed from an EUV apparatus. At optional step 302, the component is inspected. At step 303, a first layer of the component is irradiated with first ions. At optional step 304, a property is determined. At optional step 305, the component is moved. At optional step 306, a second region of the component is irradiated with first ions. At optional step 307, a second layer of the component is irradiated with second ions. At optional step 308, atoms are deposited on the component.

The method 300 provides a way of maintaining a multilayer optical component. That is, the method 300 may allow for nominal performance of the component to be achieved for a previously impaired component. For example, a component that has been contaminated, blistered or undergone blending may be repaired using the method 300. The component may have been impaired in some other way. It will be appreciated that the method 300 may be used to maintain a component that has not been damaged but has provided reduced performance for other reasons. Furthermore, the optical performance of the component may not have reduced by a measureable amount prior to maintenance using the method 300. In other words, the method 300 may be performed regularly in a pre-emptive manner to prevent a reduction in performance.

The method 300 may be used to maintain any appropriate multilayer optical component. The component may be configured for use with a lithographic process. The lithographic process may be an EUV lithographic process or a DUV lithographic process. For example, the component may be the mirror 200A. The component may be any other mirror used in a lithographic apparatus (such as the lithographic apparatus LA). For example, the component may be, or may be a mirror of, the facetted field mirror device 10 and facetted pupil mirror device 11. The component may be a mirror 13, 14 of the projection system, a collector mirror of the radiation source SO and / or the patterning device MA. While the component has been described as a component of the lithographic apparatus LA, it will be appreciated that the component may be any other component for use with a lithographic process. For example, the component may be a component of a lithographic tool (i.e. a tool configured to pattern a substrate with radiation). As a further example, the component may be a component of a metrology tool (i.e. a tool configured to measure a characteristic of a lithographic apparatus or substrate patterned by a lithographic apparatus).

While the method 300 has been described in relation to particular example steps, it will be appreciated that the method 300 may be iterative with one or more steps repeated. For example, at step 302, the component may be inspected for a first time. At step 303, a first layer of the component may be irradiated with first ions. After irradiating with first ions, the component may be inspected for a second time.

At optional step 301, the component is removed from an apparatus. For example, in examples in which the component is a mirror in a lithographic apparatus, the mirror may be removed from a mount. In examples in which the component is a patterning device, the patterning device may be removed from a support structure. The method may further comprise providing the component on, or securing the component to, a support structure. That is, the support structure may be a mount, or any other support, to releasably secure the component in a position. The support structure may be in a housing.

The method 300 may further comprise reducing a pressure. That is, the pressure may be reduced to below atmospheric pressure. In particular, the pressure may be reduced to a relative vacuum i.e. a pressure well below atmospheric pressure.

At optional step 302, the component may be inspected. For example, the component may be inspected by use of a tool. The component may be inspected to determine the cause of a performance reduction (e.g. contamination / blistering / blending). Additionally or alternatively, the inspection may determine which layer of the component is impaired and / or identify a region of a layer that is impaired. The inspection may determine a property of the impaired layer. In particular, the inspection may determine what the material composition of the impaired layer is. The inspection may determine a property of a layer adjacent to the impaired layer. In particular, the inspection may determine what the material composition of the adjacent layer is. The one or more properties determined by the inspection may be used to determine a property of the first ions. For example, the material composition of the impaired and the material composition of the adjacent layer may be used to determine an energy and / or an ion species of the first ions.

At step 303, a first layer of the component is irradiated with first ions. The first ions may have an energy at or above a sputter threshold for the first layer. Upon the first ions colliding with atoms of the first layer, momentum and energy will be transferred from the first ions to the atoms. The transferred momentum and energy may be sufficient for the atoms to be ejected. Thus, atoms of the first layer may be removed. The atoms may be ejected as individual atoms, molecules or clusters of atoms. Typically, atoms that form a surface of the first layer may be ejected. However, secondary collisions may occur and atoms below the surface of the first layer may be ejected. In summary, atoms of the first layer may physically sputter. While physical sputtering has been described, it will be appreciated that other mechanisms may cause atoms to be ejected. For example, chemical sputtering may occur.

The first layer may be an exposed layer of the component. In some examples, the first layer may be a top most layer of the component. For example, if the component is the mirror 200A, the first layer may be the layer 241. As an alternative example, if the component is the patterning device 200B, the first layer may be the absorber 261 or the layer 253. There may a second layer below the first layer. That is, the first and second layers may be substantially adjacent to one another with the first layer at least partially obscuring the second layer. The first layer may be the impaired layer. That is, the first layer may be contaminated or damaged in some way, thus reducing performance of the component. Additionally or alternatively, the first layer may not be impaired and another layer, below the first, may be the impaired layer.

A region of the first layer may be irradiated by the first ions. It will be appreciated that the region of the first layer may be any appropriate region. For example, the region may correspond to an entire surface of the first layer. As such, atoms from the entire surface of the first layer may be ejected. As an alternative, the region may be less than the entire surface of the first layer. For example, the region may be a region of the surface of the first layer that is impaired. As such, atoms in (and / or proximal to) the impaired region may be ejected. As an alternative example, the region may correspond to a region of another layer that is impaired. That is, where the second layer is impaired, the region of the first layer that obscures the impaired region of the second layer may be removed.

In some examples, an entire depth of the first layer may be removed. That is, the irradiating 303 with first ions may continue such that all atoms within the region of the first layer are removed. Thus, the second layer may be exposed within the region. In other examples, less than an entire depth of the first layer may be removed. For example, if the component has been contaminated, the contaminant particles may have accumulated on the surface of the first layer. Thus, by removing atoms at, or near to, the surface of the first layer, the contaminant particles may be removed. That is, it may not be necessary to remove atoms of the first layer that are distal to the surface. Similarly, it may not be necessary to remove atoms of the second layer.

Irradiating 303 the first layer with first ions may comprise irradiating the first layer with any appropriate species of ions. The ions may be noble gases. In particular, helium ions, argon ions, xenon ions, neon ions and / or krypton ions may be used. Additionally or alternatively, the ions may comprise hydrogen. For example, the ions may be hydrogen ions, ammonia (NH₃) ions or hydrocarbon (CₓH_{y} where x, y can be any number) ions. It will be appreciated that silicon, carbon and boron may form volatile compounds with hydrogen. As such, ions comprising hydrogen may cause atoms of the first layer to be ejected due to chemical sputtering.

The sputter threshold for the first layer may be referred to as a first sputter threshold. The first sputter threshold may be dependent on the species of ions. The first sputter threshold may also be dependent on the material composition of the first layer, That is, the first sputter threshold may be dependent onthe species of the atoms of the first layer that are to be ejected. Below the first sputter threshold, the ions may lack sufficient energy and / or momentum to induce atoms of the first layer to be ejected. As such, minimal atoms of the first layer may be ejected if the first ions have an energy below the first sputter threshold. In particular, no atoms of the first layer may be ejected. Sputter thresholds and yields may be determined based on empirical equations. For example, online tools such as that at available at https://www2.iap.tuwien.ac.at/www/surface/sputteryield may be used to determine the first sputter threshold. Table 1 shows some example sputter thresholds for species of ions mentioned above:

| Threshold (eV) | H | He | Ne | Ar | Kr | Xe |
|---|---|---|---|---|---|---|
| Ta | 699.40 | 138.65 | 35.30 | 29.25 | 32.46 | 39.34 |
| Ru | 289.43 | 63.36 | 24.58 | 25.78 | 35.18 | 46.73 |
| Mo | 275.39 | 61.03 | 24.73 | 26.46 | 36.68 | 49.05 |
| Si | 48.22 | 18.26 | 22.37 | 34.22 | 61.45 | 91.14 |
| B | 27.79 | 21.73 | 52.25 | 92.15 | 181.00 | 277.31 |
| C | 37.87 | 27.19 | 61.58 | 107.38 | 209.49 | 320.21 |
| Sn | 163.21 | 34.54 | 11.78 | 11.61 | 15.04 | 19.54 |

As an example, for atoms of a first layer comprising silicon to be ejected by argons ions, the argons ions may have an energy of at least 34.22 eV.

Irradiating 303 the first layer with first ions may comprise irradiating the first layer with ions with an energy below a second sputter threshold. The second sputter threshold may be dependent on the species of ions being used and atoms for which ejection should be minimised. The atoms for which ejection should be minimised may be atoms of the second layer. In other words, the second sputter threshold may be the sputter threshold for the species of ions to sputter atoms of the second layer. Thus, by irradiating the first layer with ions with an energy below a second sputter threshold, ejection of atoms of the second layer may be minimised.

As an example, for atoms of a first layer comprising silicone to be ejected by argon ions, while minimising ejected of atoms of a second layer comprising boron carbon, the argons may have an energy of less than 92.15 eV.

It will be appreciated that the energy of the first ions may be a spectrum. That is, the first ions may not all be provided at with the same energy. As such, the nominal energy of the first ions may be selected based on a width of the spectrum. It will also be appreciated that a yield (i.e. an amount of atoms that are ejected) may be dependent on the energy of the first ions. Thus, the energy of the first ions may be maximised to increase the yield for the first layer, while ensuring the energy is below the second sputter threshold to minimise ejection of the second atoms.

The first ions may have an energy which is below the second sputter threshold by at least a value of a safety margin. The value of the safety margin may be selected based on a width of an energy spectrum of the ions. That is, the safety margin may depend on the energy resolution of the ions. Thus, by taking the safety margin into account, minimal atoms of the second layer may be ejected. Using inequalities, the energy of the first ions may be shown as:

### First sputter threshold < First energy < Second sputter threshold - safety margin

The safety margin may be referred to as a factor. As shown above, the safety margin may be subtracted from the second sputter threshold. As an example value, the safety margin may be 5 eV. The safety margin may be 3 eV or 4 eV. As an alternative example value, the safety margin may be 10 eV. As a further example, the safety margin may be a multiplicative factor. That is, the second sputter threshold may be multiplied by the safety margin. The safety margin may be, for example, 0.9 or 0.95. Using a multiplicative factor, the first energy may be shown as:

### First sputter threshold < First energy < Second sputter threshold * safety margin

At optional step 304, a property is determined. For example, a mass spectrometer may be used to determine the property. The property may be a property of atoms ejected from the first layer. For example, the property may be a mass or mass distribution of the ejected atoms. Additionally or alternatively, the property may be a number or rate of ejected atoms. The property may be a property of the first ions. For example, the property may be an energy or energy spectrum of the first ions. In particular, the energy spectrum of the first ions may be determined based on a mass distribution of the ejected ions. The property may be a presence of an impaired layer. In other words, the presence of blisters may be detected.

In response to determining the property 304, a property of the first ions may be adjusted. For example, an energy of the ions may be increased or decreased. In particular, the mass distribution may indicate that atoms (e.g. atoms of the second layer) are being unintentionally ejected. In response, the energy of the first ions may be decreased. As an alternative example, the number or rate of ejected atoms may indicate that the sputter yield may be increased. In response, the energy of the first ions may be increased.

In response to determining the property 304, the irradiation of the region of the first layer by the first ions may be ended. That is, the rate of ejected atoms may indicate that a sufficient number of atoms of the first layer have been removed. The component may be moved such that a second region of the first layer is irradiated with ions. Additionally or alternatively, the irradiation by first ions may be stopped.

At optional step 305, the component is moved. For example, a support structure on which the component is provided may be moved. Thus, a beam of first ions may irradiate multiple regions of the first layer. The first ions may continuous to irradiate the first layer as the component is moved. Alternatively, irradiation with the first ions may stop for a period, while the component is moved, and then the irradiation may be resumed. As an alternative, an ion source may be moved such that a different region of the component is irradiated with first ions.

At optional step 306, a second region of the component is irradiated with first ions. Thus, atoms from the first layer may be ejected from the second region. The second region may be formed of the same or similar material as the first region. As such, ions used to irradiate the second region may have the same or similar properties to the ions used to irradiate the first region. In particular, the same species and / or energy of ions may be used to irradiate the first and second regions.

At optional step 307, the second layer of the component is irradiated with second ions. The second ions may cause atoms of the second layer to be ejected in a similar manner as described above in relation to step 303. As such, individual layers of the multilayer optical component may be removed. The individual layers may be removed subsequent to one another.

The second ions may be selected in a similar manner as described above in relation to the first ions.

In some examples, the second layer may be irradiated with second ions in response to the property being determined at step 304. For example, the property may be a rate of atoms being removed and the rate may fall below a threshold. The rate falling below a threshold may indicate that the first layer has been removed.

As mentioned above, in some examples (e.g. when the first layer is impaired), it may not be necessary to remove atoms of the second layer. In such examples, irradiation of the second layer with second ions 307 may not be performed. In other examples (e.g. in which a layer other than the first layer is impaired), it may be necessary to remove atoms of the second layer. It may also be necessary to remove atoms of additional layers. Atoms of additional layers may be ejected by irradiation of the additional layers by respective ions. Atoms of additional layers may be removed until an appropriate amount of atoms of an impaired layer has been removed. That is, if the impaired layer is below multiple other layers, corresponding regions of the multiple other layers may be removed prior to atoms of the impaired layer may be removed.

At optional step 308, atoms are deposited on the component. That is, atoms may be deposited on the component to reform a layer that has at least partially been removed. In other words, removed layers may be replaced. Each layer that has been at least partially removed may be replaced. The replacement of layers may be performed in reverse order compared to an order in which layers are removed. For example, if the first, second and third layers were removed, the third, second and first layers may be replaced.

The atoms may be deposited using thin film deposition. For example, physical vapour deposition (PVD), atomic layer deposition (ALD) and / or chemical vapour deposit (CVD).

In some examples, atoms may be deposited on the component by irradiating, with ions, a particle source. This irradiation may cause particles to be ejected from the particle source such that the particles accumulate on the component. Each particle may comprise one or more atoms. The particle source may comprise ruthenium, molybdenum, silicon, boron and / or carbon. The particle source may be selected to provide appropriate particles for the layer that is to be reformed.

As an example of the method 300, a mirror may comprise layers formed of Ru, Si, Mo and Si (i.e. as first, second, third and fourth layers respectively). To remove the first layer comprising, xenon ions may be selected. That is, helium ions may be vetoed as the sputter threshold (for helium ions) for Si is less than the sputter threshold for Ru. As such, it would not be possible to irradiate the mirror with helium ions such that the helium ions induce sputtering of the Ru layer without inducing sputtering of the Si layer. Neon ions may be vetoed for similar reasons. Out of argon, krypton and xenon ions, the largest difference in the respective sputter thresholds for Ru and Si is for xenon. Thus, xenon ions may be selected for irradiating the Ru layer. The energy of the xenon ions may be selected as 85 eV. That is, the energy may be selected so that the energy of the ions is above the sputter threshold for the Ru layer and below the sputter threshold for the Si layer. For example, a safety margin of 5 eV may be used. Thus, the xenon ions may be provided at an energy of the sputter threshold for the second layer minus the safety margin. In this example, the sputter threshold for Si (the second layer) is 91.14 eV and so a target energy of approximately 85 eV may be selected for the xenon ions.

Similar considerations may apply to selecting ions for removing the Si layer while minimising removal of the Mo layer. Argon, krypton and xenon ions may be vetoed. Neon ions may also be vetoed due to the sputter thresholds for Mo and Si being similar. As such, He ions may be selected. The sputter threshold for He ions and Si is 61.03 eV. Using a satisfy margin of 5 eV, He ions of approximately 55 eV may be selected.

Xenon ions may also be used to irradiate the third layer comprising Mo. Irradiating the mirror in this way may provide a yield of 0.021 and 0.046 for the Ru and the Mo atoms, respectively. Layers formed of Si that are irradiated with helium ions may provide a yield of 0.012. Similar yields may be achieved for layers comprising boron and / or carbon. Using an ion source with a current of 1A to irradiate a mirror with a 10 cm diameter, it is expected that any particular layer could be removed in less than 2 s. For example, a layer comprising carbon could be removed in less than 1.2 s.

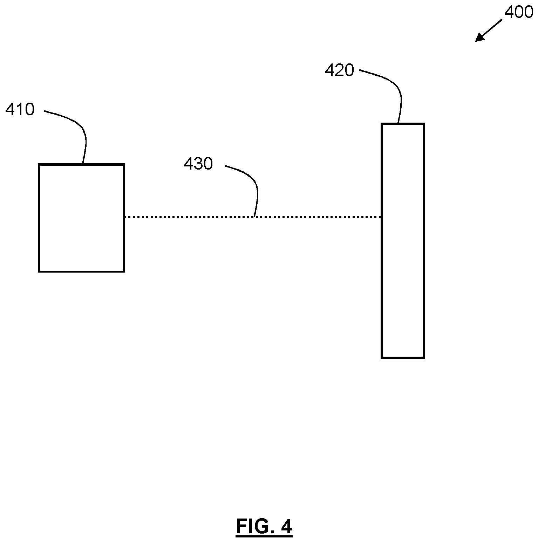

Figure 4 depicts an example apparatus 400 for maintaining a multilayer optical component 420. That is, the apparatus 400 may be used to perform the method 300.

The apparatus 400 comprises an ion source 410. The ion source 410 provides ions 430 such that a component 420 may be irradiated. The ion source 410 may be, for example, a magnetron. The magnetron may be linear. In some examples, the ions source 410 may be an inverted magnetron ion source.

The ion source 410 may be configured to provide helium ions, argon ions, xenon ions, neon ions and / or krypton ions. The ions source 410 may be configured to selectively provide a particular species of ions. The ions source 410 may be configured to provide ions at a selectable energy. In particular, the ions may be provided at a selectable energy in the 10 - 500 eV range. Thus, the ion source 410 may be able to provide ions at an energy above a first sputter threshold and, optionally, below a second sputter threshold.

The apparatus 400 may further comprise a second ion source. Beneficially, this may allow for irradiation of multiple regions and / or multiple components at a single time. Additionally or alternatively, providing the apparatus 400 with multiple ion sources may allow for each ion source to be optimized for a specific ion species and / or energy.

The apparatus 400 may further comprise a support structure, for example, a mount. The support structure may be configured to releasably secure the component 420 in a position.

The apparatus 400 may further comprise a device for moving an irradiation region. For example, the device may move the ion source 410 such that the ions 430 may irradiate different regions of the component 420. Additionally or alternatively, the device may move the component 420 such that different regions are irradiated by the ions 430.

The apparatus may further comprise a sensor. The sensor may be configured to determine a property of the atoms ejected from a layer of the component 420. Additionally or alternatively, the sensor may be configured to determine a property of the ions 430. The sensor may be a mass spectrometer.

The apparatus may further comprise a vacuum source. That is, the vacuum source may be configured to reduce a pressure. The vacuum source may be a vacuum pump. The apparatus may further comprise a housing. That is, the housing may define an environment in which the pressure may be reduced. The housing may comprise a load lock such that a component can be provided in and / or removed from the housing. In particular, the load lock may allow the component to be moved while a vacuum is substantially maintained within the housing.

The apparatus may further comprise a particle source. The particle source may be configured to, upon being irradiated by ions, eject particles. The ejected particles may be deposited on the component 420 such that removed layers may be replaced.

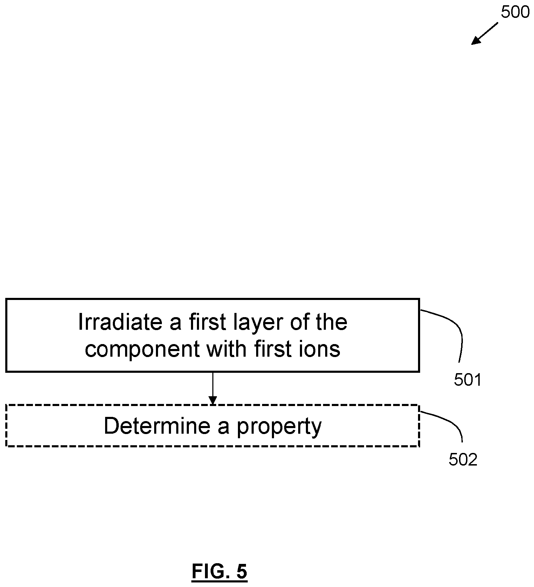

Figure 5 is a flow diagram showing a second example method 500 of maintaining a multilayer optical component. At step 501, a first layer of a component is irradiated with first ions. At optional step 502, a property may be determined.

At step 501, a first layer of a component is irradiated with first ions. In contrast to the method 300 (and step 303 in particular), at step 501 the component is irradiated with first ions with an energy below the sputter threshold for the first layer. As such, minimal (i.e. no) atoms are ejected from the first layer. However, contaminants with a sputter threshold (for the first ions) below that of the energy of the first ions may be ejected. As an example, tin may have a sputter threshold of 19.54 eV when irradiated with xenon ions. Thus, a first layer comprising Ru (with a sputter threshold of 46.73 eV for xenon ions) may be irradiated with xenon ions with an energy between 19.54 eV and 46.73 eV. Under such irradiation, the tin contaminants may be ejected and minimal (i.e. no) atoms of the first layer may be ejected. In this way, the first layer may be cleaned of contaminants.

At step 502, a property may be determined. For example, a mass spectrometry may be used. In particular, a time of flight mass spectrometer may be used. The property may be the mass of each contaminant that has been removed.

While the method 500 has been described in relation to the steps 501 and 502, it will be appreciated that other steps of the method 300 may be used in the method 500.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of maintenance for a multilayer optical component configured for use with a lithographic process and comprising at least a first layer and a second layer adjacent to the first layer, the method comprising:
irradiating, with first ions, a region of the first layer such that particles are ejected from the first layer,
wherein the first ions have an energy at or above a sputter threshold of the first layer and the energy is below a sputter threshold of the second layer.

2. The method of claim 1 wherein the lithographic process is an EUV lithographic process.

3. The method of claims 1 or 2 wherein the multilayer optical component is a mirror or a patterning device.

4. The method of any preceding claim wherein irradiating the first layer with first ions comprises irradiating the first layer with noble gas ions.

5. The method of any preceding claim wherein the first layer is a surface layer of the multilayer optical component.

6. The method of any preceding claim wherein the first layer comprises ruthenium, molybdenum, silicon, boron and / or carbon.

7. The method of any preceding claim wherein irradiating the first layer with first ions comprises irradiating the first layer with ions with an energy below the sputter threshold for the second layer by at least 5 eV.

8. The method of any preceding claim further comprising:
subsequent to irradiating the first layer, irradiating, with second ions, a second layer such that particles are ejected from the second layer.

9. The method of any preceding claim further comprising:
removing the multilayer optical component from an EUV apparatus; and
subsequent to removing the multilayer component from the EUV apparatus, irradiating the first layer with first ions.

10. The method of any preceding claim further comprising:
reducing a pressure to below ambient pressure.

11. The method of any preceding claim further comprising:
after irradiating a first region of the first layer with ions, moving the multilayer optical component; and
irradiating, with first ions, a second region of the first layer such that particles are ejected from the second region.

12. The method of any preceding claim further comprising:
determining a property of the particles ejected from the region.

13. The method of any preceding claim further comprising:
determining a property of the first ions.

14. The method of claims 12 or 13 further comprising:
in response to determining the property of the particles and / or the property of the first ions, adjusting a property of the first ions.

15. The method of any preceding claim:
for at least one layer of the component from which particles have been ejected, depositing atoms on the component to at least partially form a layer.

16. An apparatus configured to perform the method of any preceding claim.

17. Non-transitory computer-readable memory storing instructions, which, when executed causes one or more computer systems to control an apparatus to perform the method of any one of claims 1 to 15.

18. A computer system, the computer system comprising:
a plurality of processors:
one or more non-transitory computer readable media storing computer readable instructions that when executed cause the plurality of processors to perform the method of any one of claims 1 to 15.

19. A multilayer optical component configured for use with a lithographic process that has been maintained according to the method of any one of claims 1 to 15.

20. A lithographic apparatus comprising the multilayer optical component of claim 19.

21. A lithographic tool comprising the multilayer optical component of claim 19.

22. An apparatus for maintaining a multilayer optical component configured for use with a lithographic process and comprising at least a first layer and a second layer adjacent to the first layer,, the apparatus comprising:
an ion source configured to, in use, irradiate a region of the first layer with first ions wherein:
the first ions have an energy at or above a sputter threshold of the first layer such that particles are ejected from the first layer; and
the first ions have an energy below a sputter threshold of the second layer.

23. The apparatus of claim 22 wherein the ion source is linear.

24. The apparatus of claims 22 or 23 wherein the ion source is an inverted magnetron ion source.

25. The apparatus of claims 22, 23 or 24 wherein the ion source is a source of noble gas ions.

26. The apparatus of any one of claims 22 to 25 wherein the ion source is configured to provide ions at a selectable energy.

27. The apparatus of any one of claims 22 to 26 further comprising
a component configured to releasable secure the multilayer optical component.

28. The apparatus of any one of claims 22 to 27 further comprising:
a component configured to move the multilayer optical component.

29. The apparatus of any one of claims 22 to 28 further comprising:
a mass spectrometer.

30. The apparatus of any one of claims 22 to 29 further comprising:
a vacuum source.

31. The apparatus of any one of claims 22 to 30 further comprising:
a second ion source configured to, in use, irradiate a layer of the multilayer optical component with second ions such that particles are ejected from the layer.

32. The apparatus of any one of claims 22 to 31 further comprising:
a particle source configured to, in use and upon exposure to ions, eject particles such that the ejected particles accumulate on the multilayer optical component.
